# EUROPEAN PATENT SPECIFICATION

(11) **EP 0 477 374 B1**
(45) Date of publication and mention of the grant of the patent: **09.07.1997**
(21) Application number: 91906249.7
(22) Date of filing: 14.03.1991
(51) Int. Cl.: C30B 25/02, C30B 29/40, H01L 21/205

(54) **PROCESS FOR GROWING SEMICONDUCTOR CRYSTAL**
VERFAHREN ZUM ZÜCHTEN EINES HALBLEITERKRISTALLS
PROCEDE DE CROISSANCE D'UN CRISTAL SEMICONDUCTEUR

(30) Priority: 14.03.1990 JP 610/89
(43) Date of publication of application: 01.04.1992
(73) Proprietor: FUJITSU LIMITED, Kawasaki-shi, Kanagawa 211 (JP)
(72) Inventor: KURAMATA, Akito, Sagamihara-shi, Kanagawa 228 (JP)
(74) Representative: Joly, Jean-Jacques
(86) International application number: JP9100349
(87) International publication number: WO9114280

(56) References cited:
- EP-A- 0 296 257
- JP-A- 1 259 524
- JP-A- 5 074 970
- JP-A- 5 854 627
- US-A- 4 814 203
- FUJITSU-SCIENTIFIC & TECHNICAL JOURNAL, vol. 25, no. 2, 1989, Kawasaki (JP) pages 146 - 155; MAKOTO KONDO ET AL.: 'Low-pressure matalorganic vapor phase epitaxial growth of InGaAsP/InP quantum well structures'
- APPLIED PHYSICS LETTERS, vol. 48, no. 22, 02 June 1986, NEW YORK US pages 1531 - 1533; C.A. LARSEN ET AL.: 'Organometallic vapor phase epitaxial growth of InP using new phosphorous sources'
- JOURNAL OF APPLIED PHYSICS, vol. 64, no. 7, 01 October 1988, NEW YORK US pages 3684 - 3688; T. KAWABATA ET AL.: 'Metalorganic chemical vapor deposition of InGaAsP/InP layers and fabrication of 1.3um planar buried heterostructure lasers.'
- LECTURE PREPARATIONS for the 36th Appl. Phys. related joint lecture, (1989-4-1), p. 334 [ Lecture No. 3p-ZN-6 ]
- Appl. Phys. Lett. 50 [ 17 ], (1987-4), p. 1194-1196
- Appl. Phys. Lett. 50 [ 4 ], (1987-4), p. 218-220

## Description

The present invention relates to a process for growing a semiconductor crystal, and more particularly to a process for growing a mixed crystal by MOVPE (metal organic vapor phase epitaxy).

### BACKGROUND ART

AsH₃ , PH₃ and trimethylantimony (TMSb) have hitherto been utilized as a group V element source in MOVPE. For example, In_{0.77}Ga_{0.23}As_{0.51}P_{0.49} is grown under the following conditions.

| | |
|---|---|
| Flow rate: | |
| Trimethylindium (TMI) | 0.400 cc/min |
| Triethylgallium (TEG) | 0.110 cc/min |
| Arsine (AsH₃) | 1.98 cc/min |
| Phosphine (PH₃) | 98.0 cc/min |
| Hydrogen (H₂) | 640 cc/min |
| Pressure: | 0.1 atm |
| Substrate temperature: | 600°C |

In the MOCVD, since the decomposition of the group III element sources is stable, the distribution of the composition of the group III elements in the grown crystal along the flow of the gas is small, that is, the composition is homogeneous. On the other hand, in the group V element sources, since the source gases are very different from each other in the decomposition rate, there occurs a large distribution of the composition of the group V elements along the flow of the gas from the upstream portion toward the downstream portion of the substrate. For example, in the growth of the above-described In_{0.77}Ga_{0.23}As_{0.51}P_{0.49} , the composition of which has a photoluminescence (PL) wavelength of 1.2 µm, there occurs such a large distribution of the composition (unevenness) that the PL wavelength varies by about 20 nm in a distance of 25 mm from the upstream to downstream portions along the gas flow.

This phenomenon is becoming a large problem in the InGaAsP crystal used as a material for a long wavelength laser from a practical point of view. Accordingly, an object of the present invention is to provide a method for further homogenizing the composition distribution of the group V elements.

### DISCLOSURE OF THE INVENTION

In order to attain the above-described object, the present invention provides a process for growing a semiconductor crystal which comprises growing a group IV-V group compound semiconductor containing As and P by metal organic vapor phase epitaxy, characterized in that H₂AsCₙH₂ₙ₊₁ (wherein n is 1 or 2) is used as an As source and H₂PC₄H₉ as a P source. Also, there is provided a process for growing a semiconductor crystal, characterized in that metal organic vapor phase epitaxy is conducted in a vacuum atmosphere through the use of arsine (AsH₃) as an As source and H₂PC₄H₉ as a P source. Preferred embodiments according to the processes of the invention are disclosed in dependent claims 2 to 5 and 7 to 10. Since H₂AsCₙH₂ₙ₊₁ (wherein n is 1 or 2) and AsH₃ exhibit a decomposition rate close to H₂PC₄H₉ , there occurs no large distribution of the composition between As and P along the flow of the gas. The in-plane uniformity is very high particularly with the growth in a vacuum atmosphere according to the present invention. Further, H₂PC₄H₉ is safer in handling than the conventional P source of PH₃. In the compound semiconductor used in the present invention, there is no particular limitation on other elements and composition as far as As and P are contained as the group V element. The compound semiconductor used in the present invention is effective for growing InGaAsP on an InP substrate or a GaAs substrate, particularly on an InP substrate. This is because InₓGa₁₋ₓAs_{1-y}P_{y} wherein y = (-0.22 + 0.4x)/(0.2 - 0.02x) having a lattice constant matching an InP substrate is particularly used as a material for a long wavelength band laser, and according to the present invention, such a mixed crystal can be grown in a homogeneous composition distribution. (100) plane and (111) plane are preferably used in the InP substrate and GaAs substrate, respectively.

There is no particular limitation on the group III element source gas, and the conventional source gas may be used. For example, trimethylindium and triethylindium are used as the In source, and triethylgallium, trimethylgallium, etc. are used as the Ga source.

The flow rates of the source gases vary depending upon the kind of the gas, growth temperature, etc. In general, however, for example, when P and As are grown in a P/As ratio (molar ratio), the flow rate ratio of the As source gas (H₂AsCₙH₂ₙ₊₁ or AsH₃) to the P source gas (H₂PC₄H₉) is log(P/AS)_{c} = 0.6564 log (P/As)ᵣ - 0.7631 wherein (P/AS)_{c} is P/As ratio of the crystal and (P/As)ᵣ is P/As ratio of the source, and the flow rate ratio of the group III source gas to the group V source gas, for example, in the case of In and Ga, is log (In/Ga)_{c} = 0.9107 log (In/Ga)ᵣ + 0.0261 wherein (In/Ga)_{c} is In/Ga ratio of the crystal and (In/Ga)ᵣ is In/Ga ratio of the source.

Hydrogen, nitrogen, helium and other gases are generally used as the carrier gas. When the amount of the carrier gas is excessively small, it is difficult to attain a homogeneous flow of the source gas. On the other hand, when the amount of the carrier gas is excessively large, the substrate is cooled, so that the decomposition rate of the source gas is lowered. For this reason, the total flow rate of the carrier gas and the source gas is preferably 1 to 10 liters/min, and more preferably about 6 liters/min.

There is no particular limitation on the growing temperature as far as H₂AsCₙH₂ₙ₊₁ wherein n is 1 or 2 and H₂PC₄H₉ are used as the source gas. However, the growth temperature is generally 500 to 650°C, and preferably 570 to 620°C.

The pressure may be atmospheric pressure or reduced pressure. When AsH₃ and H₂PC₄H₉ are respectively used as the As source and P source, however, the growth is conducted under reduced pressure, particularly under a reduced pressure of about 100 kPa (0.1 atm).

It is preferable to rotate the substrate during the growth, from the viewpoint of homogenizing the film thickness and composition distribution. The film thickness and composition distribution can further be homogenized by providing a plurality of ports rather than providing a single port for supplying a gas to the substrate, said ports being arranged along a diameter of the substrate.

According to the present invention, the group V composition of the mixed crystal semiconductor containing As and P can be homogenized within the plane of the substrate, which greatly contributes to an improvement in the yield of the semiconductor device.

### BRIEF DESCRIPTION OF DRAWINGS

Fig. 1 is a graph showing the distribution of the PL wavelength of InGaAsP grown by MOVED;
Fig. 2 is a schematic diagram of an apparatus for growing a crystal by MOVED;
Fig. 3 is a schematic diagram showing the introduction of a source gas into a substrate within an apparatus for growing a crystal by MOVED;
Figs. 4 to 6 are graphs showing the PL wavelength distribution of InGaAsP grown by MOVED in the embodiments that will be described later; and
Fig. 7 is a schematic cross-sectional view of a semiconductor laser.

### BEST MODE FOR CARRYING OUT THE INVENTION

As described above, in the present invention, a combination of sources having decomposition rates close to each other is used as means for solving the problems of the prior art.

The composition distribution (unevenness) in the direction of the flow of InGaAsP reaches maximum near a position where the As composition becomes substantially equal to the P composition. In InGaAsP which matches in lattice constant with InP, a crystal having a PL wavelength around 1.2 µm corresponds to such a composition. The growth of InGaAsP having a PL wavelength around 1.2 µm which matches in lattice constant with InP is conducted through a combination of three sources, and the distribution of the group V composition is reflected in the PL wavelength distribution.

In the first experiment, use was made of three kinds of combination, i.e., AsH₃ + PH₃, AsH₃ + tBPH₂ and tBAsH₂ + tBPH₂. As a result, it has been found that the difference in the PL wavelength between the upstream portion and the downstream portion correlates to the difference in the decomposition rates of the sources. The following table shows the decomposition rates of PH₃, AsH₃ , tBPH₂ and tBAsH₂ in terms of the temperature at which there occurs 50% decomposition in a given period of time taken for the source to pass through the heating region.

| Source | Time taken for gas to pass through heating region (sec) | 50% decomposition temp.(°C) | Source of data |
|---|---|---|---|
| PH₃ | 10 | 800 | J.C.G.68(1984)111 |
| AsH₃ | 9.6 | 560 | J.C.G.77(1986)188 |
| tBPH₂ | 8.1 | 460 | J.C.G.96(1989)906 |
| tBAsH₂ | 8.1 | 360 | J.C.G.94(1989)663 |

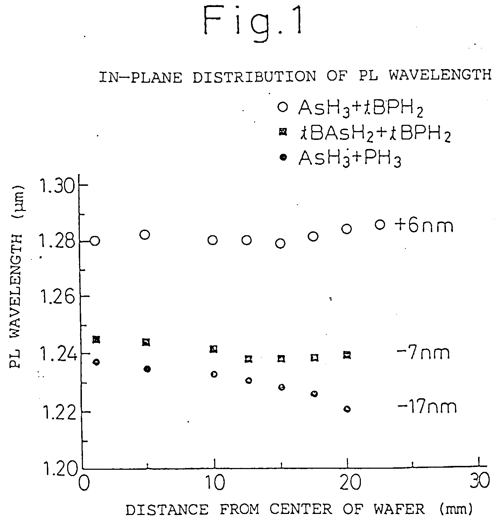

The results are shown in Fig. 1. The abscissa represents the distance from the center of the wafer, and the ordinate represents the PL wavelength. Numerals in the drawing represent the degree of change in the PL wavelength from the center of the wafer to the periphery thereof. The PL wavelength was measured along a diameter of the substrate through irradiation of the substrate with a laser beam having a beam diameter of 200 µm in a scattered dot form.

In the combination of AsH₃ + PH₃ wherein the decomposition rate difference is large (240°C), the degree of change in the PL wavelength is as large as -17 nm, whereas in the remaining two combinations, i.e., AsH₃ + tBPH₂ and tBAsH₂ + tBPH₂ , wherein the decomposition rate difference is small (-100°C and +100°C, respectively), the PL wavelength differences are respectively as small as -7 nm and +6 mm.

The PL wavelength difference is preferably as small as possible from the viewpoint of the quality (yield) of the semiconductor crystal wherein the design accuracy of the semiconductor laser is taken into consideration. In the above-described AsH₃ + PH₃ and tBAsH₂ + tBPH₂ wherein (decomposition rate of As source) > (decomposition rate of P source), the P composition increases from the center towards the periphery, so that the PL wavelength shifts on the side of the short wavelength, whereas the opposite phenomenon is observed in the combination of AsH₃ + tBPH₂ wherein (decomposition rate of As source) < (decomposition rate of P source). This suggests that the in-plane distribution of the PL wavelength can further be improved when tBPH₂ is used as the P source and a source having a decomposition rate intermediate between AsH₃ and tBAsH₂ is used as the As source. In the As source represented by H₂AsCₙH₂ₙ₊₁ , the larger the n value, the higher the decomposition rate. AsH₃ and tBAsH₂ respectively correspond to the cases where n = 0 and n = 4. Therefore, the source having an n value of 1 or 2 is suitable for the above-described purpose. According to the present invention, use is made of a combination of AsH₃ or H₂AsCₙH₂ₙ₊₁ wherein n = 1 or 2, with tBPH₂. The combination of AsH₃ with tBPH₂ is preferred because it is particularly excellent in the handleability of the gas.

When the growth is conducted under atmospheric pressure with the combination of AsH₃ and tBPH₂ as the source gases, however, the In source reacts with the group V element source in a vapor phase to form a polymer, so that no good epitaxial growth of InGaAsP can be obtained. Further, the atmospheric pressure has drawbacks in that it is difficult to control the flow of the gas, the practicality is poor and the film thickness is uneven. By contrast, when the combination of AsH₃ with tBPH₂ is used under reduced pressure, the above-described drawbacks can be eliminated even in InGaAsP, so that it becomes possible to conduct epitaxial growth with suppressed composition distribution.

The growth of an In_{0.77}Ga_{0.23}As_{0.51}P_{0.49} crystal having a PL wavelength of 1.2 µm through the use of a combination of EtAsH₂ (ethylarsine) corresponding to H₂AsCₙH₂ₙ₊₁ wherein n = 2, with tBPH₂ will now be described in more detail.

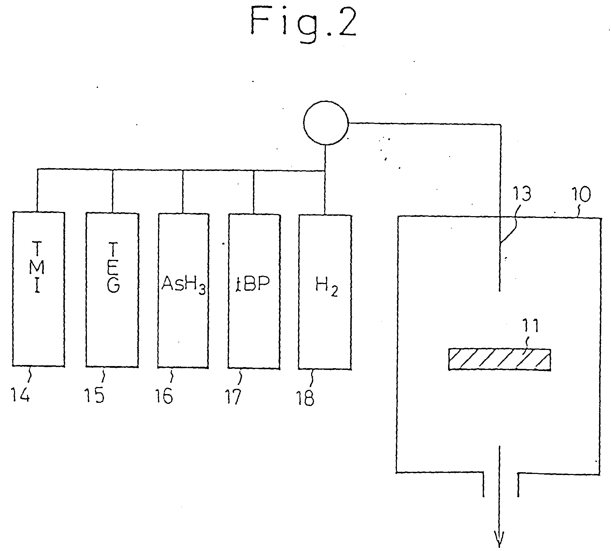

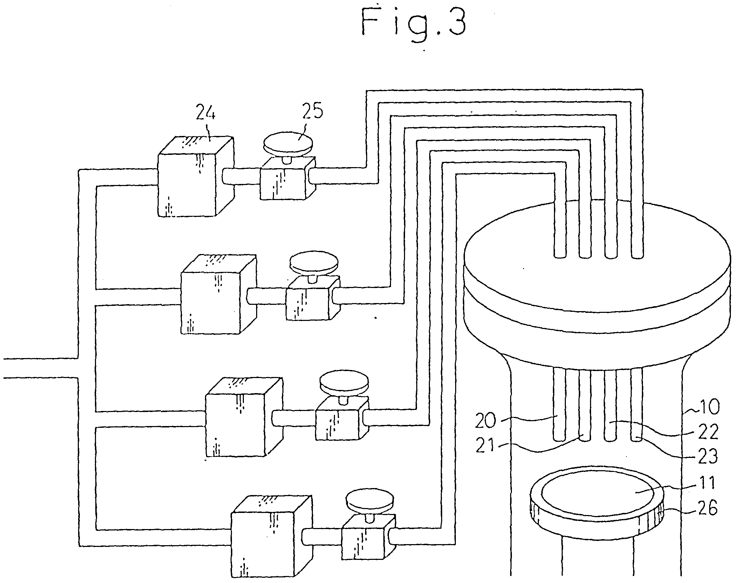

An apparatus for growing a crystal is shown in Fig. 2. A source gas is flowed on a substrate 11 within a reaction tube 10 through a gas introduction port 13 provided in the upper part of the reaction tube. The flow rates of individual source gases and a carrier gas from tanks 14 to 18 are regulated, and they are mixed with each other and fed to the reaction tube 10. Fig. 3 shows the introduction of a gas on a substrate 11 placed on a susceptor 26 within the reaction tube 10. A plurality of gas introduction ports 20 to 23 are arranged in a row in the direction of the diameter of the substrate 11. The source gas after mixing is passed through a flow meter 24 and a needle valve 25 to control the flow rate and then fed to individual gas introduction ports 20 to 23. The substrate 11 can be rotated.

Trimethylindium (TMI) and triethylgallium (TEG) were used as the In source and the Ga source, respectively. An InP(100) substrate was used as the substrate, and the substrate was protected during the rise of the temperature by flowing tBPH₂ at a flow rate of 50 cc/min. Hydrogen was used as the carrier gas, and the flow rate was controlled so that the total amount was 6.5 liters/min. The growth pressure, growth temperature and the speed of rotation of the substrate were 0.1 atm, 600°C and 60 rpm, respectively. The net flow rates of the sources were as follows.

| | |
|---|---|
| TMI | 0.3877 cc/min |
| TEG | 0.1127 cc/min |
| EtAsH₂ | 1.980 cc/min |
| tBPH₂ | 38.021 cc/min |

Under these conditions, the growth rate was 3 µm/hr.

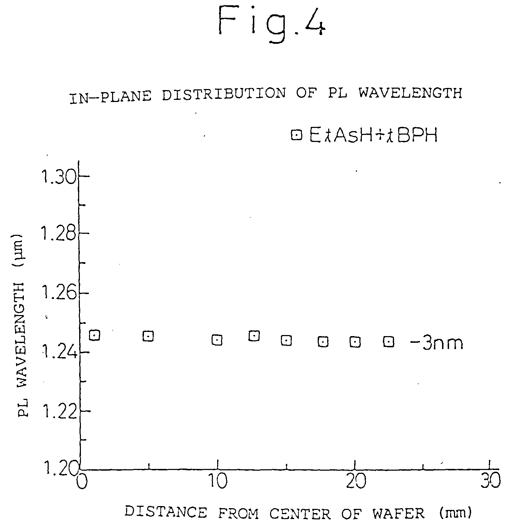

The PL wavelength difference (distance: 25 mm) of the In_{0.77}Ga_{0.23}As_{0.51}P_{0.49} (PL wavelength: 1.2 µm) grown on the InP substrate was as shown in Fig. 4 and is -3 nm.

The use of AsH₃ as the As source will now be described. In this case as well, an In_{0.77}Ga_{0.23} As_{0.51}P_{0.49} crystal having a PL wavelength of 1.2 µm which matches in lattice constant with the InP substrate was grown.

Trimethylindium (TMI) and triethylgallium (TEG) were respectively used as the In and Ga sources, respectively. An InP(100) substrate was used as the substrate, and the substrate was protected during the rise of the temperature by flowing PH₃ (20%) at a flow rate of 50 cc/min. Hydrogen was used as the carrier, and the flow rate was adjusted so that the total amount was 6.5 liters/min. The growth pressure, growth temperature and the speed of rotation of the substrate were 0.1 atm, 600°C and 60 rpm, respectively. The net flow rates of the sources were as follows.

| | |
|---|---|
| TMI | 0.3877 cc/min |
| TEG | 0.1127 cc/min |
| AsH₃ | 1.980 cc/min |
| tBPH₂ | 38.021 cc/min |

Under these conditions, the growth rate was 3 µm/hr.

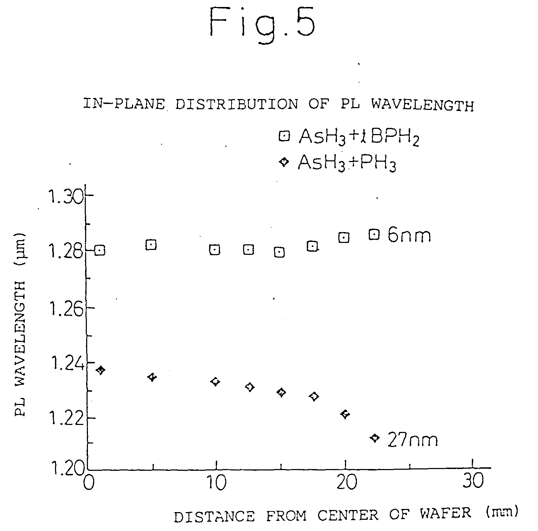

In this embodiment, as shown in Fig. 5, the difference in the PL wavelength between the upstream portion and the downstream portion was 6 nm.

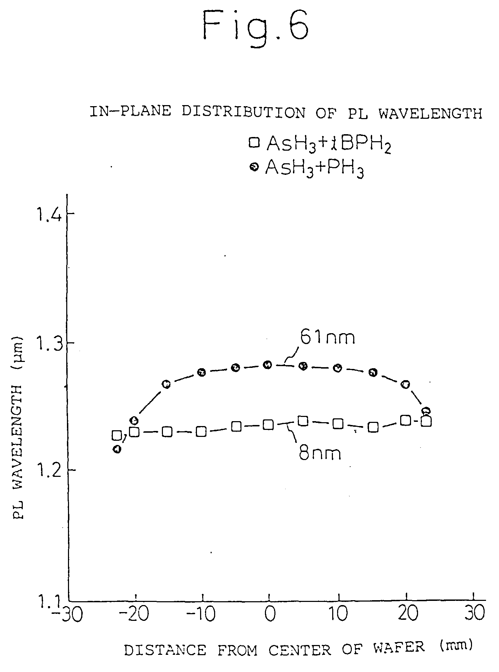

Then, an experiment was conducted through the use of a combination of AsH₃ with tBPH₂ as the source gas under the same condition as that described above, except that the growth was conducted with the rotation of the substrate stopped. The results are shown in Fig. 6. Further, for comparison, an experiment was conducted through the use of a combination of AsH₃ with PH₃ with the rotation of the substrate stopped. The results of this experiment as well are shown in Fig. 6. The PL wavelength difference was 8 nm in the case of the combination of AsH₃ with tBPH₂ , while the PL wavelength difference was 66 nm in the case of the combination of AsH₃ with PH₃. As shown in Fig. 1, in the combination of AsH₃ with PH₃ , since the PL wavelength difference is 17 nm when the substrate is rotated, the effect of homogenizing the composition derived from the rotation of the substrate is large. On the other hand, as shown in Fig. 5, in the combination of AsH₃ with tBPH₂ , the PL wavelength difference is as small as 6 nm even when the substrate is rotated. In other words, this shows that since the effect of homogenizing the composition through the selection of the source gases is inherent in the present invention, the rotation of the substrate does not contribute to further improvement in the effect of homogenizing the composition.

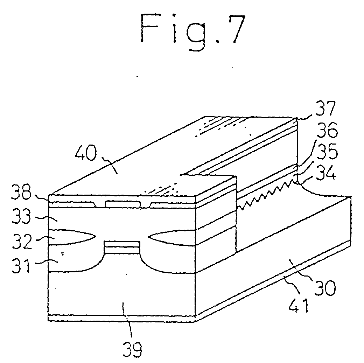

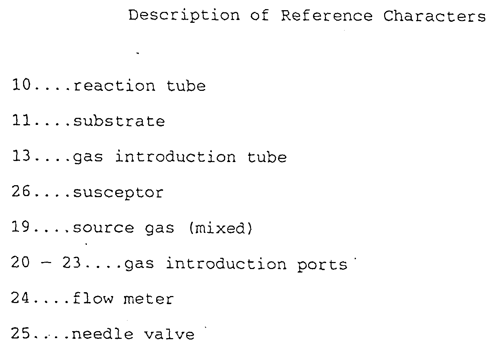

An embodiment of the production of a semiconductor laser (FBH-DFB laser) through the use of InGaAsP grown on the InP substrate according to the present invention will now be described with reference to Fig. 7. In Fig. 7, numeral 30 designates an n-InP substrate, numeral 31 a p-InP layer, numeral 32 an n-InP layer, numeral 33 a p-InP layer, numeral 34 a wave (corrugation), numeral 35 an n-GaInAsP layer, numeral 36 a GaInAsP layer, numeral 37 a p-GaInAsP layer, numeral 38 an SiO₂ layer, numeral 39 an Al₂O₃ coating, and numerals 40 and 41 each an electrode. Such a laser was prepared through the use of an InP wafer. As a result, a laser satisfying the predetermined characteristic requirements can be obtained at a very high yield, that is, the effect of the present invention was confirmed.

## Claims

1. A process for growing a crystal of a compound semiconductor containing As and P, comprising the steps of:
placing a substrate within a growth chamber; and
feeding a source gas containing H₂AsCₙH₂ₙ₊₁ (wherein n is 1 or 2) as an As source, H₂PC₄H₉ as a P source and a group III element source and heating the substrate to allow a III-V compound semiconductor containing As and P to be grown on the substrate by vapor phase epitaxy.

2. A process according to claim 1, wherein said substrate is at least one member selected from the group consisting of InP and GaAs.

3. A process according to claim 1, wherein said compound semiconductor is InGaAsP.

4. A process according to claim 3, wherein said source gas mixture comprises H₂AsCₙH₂ₙ₊₁ (wherein n is 1 or 2) as an As source, H₂PC₄H₉ as a P source, at least one member selected from the group consisting of trimethylindium and triethylindium as an In source, and at least one member selected from the group consisting of triethylgallium and trimethylgallium as a Ga source.

5. A process according to claim 1, wherein the substrate temperature is 500 to 650°C.

6. A process for growing a crystal of a compound semiconductor containing As and P, comprising the steps of:
placing a substrate within a growth chamber; and
feeding a source gas mixture containing AsH₃ as an As source, H₂PC₄H₉ as a P source and a group III element source and heating the substrate under reduced pressure to allow a III-V compound semiconductor containing As and P to grow on the substrate by vapor phase epitaxy.

7. A process according to claim 6, wherein said substrate is at least one member selected from the group consisting of InP and GaAs.

8. A process according to claim 6, wherein said compound semiconductor is InGaAsP.

9. A process according to claim 8, wherein said source gas mixture comprises AsH₃ as an As source, H₂PC₄H₉ as a P source, at least one member selected from the group consisting of trimethylindium and triethylindium as an In source, and at least one member selected from the group consisting of triethylgallium and trimethylgallium as a Ga source.

10. A process according to claim 6, wherein the substrate temperature is 500 to 650°C.

## Patentansprüche

1. Prozeß für das Wachsen eines Kristalls eines Verbindungshalbleiters, der As und P enthält, mit den Schritten:
Anordnen eines Substrats innerhalb einer Wachstumskammer; und
Zuführen eines Quellengases, das H₂AsCₙH₂ₙ₊₁ (wobei n 1 oder 2 ist) als As-Quelle, H₂PC₄H₉ als P-Quelle und eine Quelle von Elementen der Gruppe III enthält, und Erhitzen des Substrats, um einen III-V-Verbindungshalbleiter, der As und P enthält, auf dem Substrat durch Dampfphasenepitaxie wachsen zu lassen.

2. Prozeß nach Anspruch 1, bei dem das Substrat wenigstens ein Glied ist, das ausgewählt ist aus der Gruppe bestehend aus InP und GaAs.

3. Prozeß nach Anspruch 1, bei dem der Verbindungshalbleiter InGaAsP ist.

4. Prozeß nach Anspruch 3, bei dem das Quellengasgemisch H₂AsCₙH₂ₙ₊₁ (wobei n 1 oder 2 ist) als As-Quelle, H₂PC₄H₉ als P-Quelle, wenigstens ein Glied, das ausgewählt ist aus der Gruppe bestehend aus Trimethylindium und Triethylindium, als In-Quelle, und wenigstens ein Glied, das ausgewählt ist aus der Gruppe bestehend aus Triethylgallium und Trimethylgallium, als Ga-Quelle umfaßt.

5. Prozeß nach Anspruch 1, bei dem die Substrattemperatur 500 bis 650 °C beträgt.

6. Prozeß für das Wachsen eines Kristalls eines Verbindungshalbleiters, der As und P enthält, mit den Schritten:
Anordnen eines Substrats innerhalb einer Wachstumskammer; und
Zuführen eines Quellengasgemisches, das AsH₃ als As-Quelle, H₂PC₄H₉ als P-Quelle und eine Quelle von Elementen der Gruppe III enthält, und Erhitzen des Substrats unter reduziertem Druck, um einen III-V-Verbindungshalbleiter, der As und P enthält, auf dem Substrat durch Dampfphasenepitaxie wachsen zu lassen.

7. Prozeß nach Anspruch 6, bei dem das Substrat wenigstens ein Glied ist, das ausgewählt ist aus der Gruppe bestehend aus InP und GaAs.

8. Prozeß nach Anspruch 6, bei dem der Verbindungshalbleiter InGaAsP ist.

9. Prozeß nach Anspruch 8, bei dem das Quellengasgemisch AsH₃ als As-Quelle, H₂PC₄H₉ als P-Quelle, wenigstens ein Glied, das ausgewählt ist aus der Gruppe bestehend aus Trimethylindium und Triethylindium, als In-Quelle, und wenigstens ein Glied, das ausgewählt ist aus der Gruppe bestehend aus Triethylgallium und Trimethylgallium, als Ga-Quelle umfaßt.

10. Prozeß nach Anspruch 6, bei dem die Substrattemperatur 500 bis 650 °C beträgt.

## Revendications

1. Procédé permettant de faire croître un cristal d'un semiconducteur composé contenant As et P, qui comprend les opérations suivantes :
placer un substrat à l'intérieur d'une chambre de croissance ; et
envoyer un mélange de gaz source contenant H₂AsCₙH₂ₙ₊₁ (où n vaut 1 ou 2) comme source de As, H₂PC₄H₉ comme source de P et une source d'élément du groupe III, et chauffer le substrat afin de permettre qu'un semiconducteur composé des groupes III-V, contenant As et P, croisse sur le substrat par épitaxie en phase vapeur.

2. Procédé selon la revendication 1, où ledit substrat est au moins un élément choisi dans le groupe constitué par InP et GaAs.

3. Procédé selon la revendication 1, où ledit semiconducteur composé est InGaAsP.

4. Procédé selon la revendication 3, où ledit mélange de gaz source comprend H₂AsCₙH₂ₙ₊₁ (où n vaut 1 ou 2) comme source de As, H₂PC₄H₉ comme source de P, au moins un membre choisi dans le groupe constitué du triméthylindium et du triéthylindium comme source de In, et au moins un membre choisi dans le groupe constitué du triéthylgallium et du triméthylgallium comme source de Ga.

5. Procédé selon la revendication 1, où la température du substrat est de 500 à 650°C.

6. Procédé permettant de faire croître un cristal d'un semiconducteur composé contenant As et P, qui comprend les opérations suivantes :
placer un substrat à l'intérieur d'une chambre de croissance ; et
fournir un mélange de gaz source contenant AsH₃ comme source de As, H₂PC₄H₉ comme source de P et une source d'élément du groupe III, et chauffer le substrat sous pression réduite afin de permettre qu'un semiconducteur composé des groupes III-V contenant As et P croisse sur le substrat par épitaxie en phase vapeur.

7. Procédé selon la revendication 6, où ledit substrat est au moins un membre choisi dans le groupe constitué de InP et GaAs.

8. Procédé selon la revendication 6, où ledit semiconducteur composé est InGaAsP.

9. Procédé selon la revendication 8, où ledit mélange de gaz source comprend AsH₃ comme source de As, H₂PC₄H₉ comme source de P, au moins un membre choisi dans le groupe constitué du triméthylindium et du triéthylindium comme source de In, et au moins un membre choisi dans le groupe constitué du triéthylgallium et du triméthylgallium comme source de Ga.

10. Procédé selon la revendication 6, où la température du substrat est de 500 à 650°C.
